**Europäisches Patentamt**

**European Patent Office**

**Office européen des brevets**

(19)

(11) Veröffentlichungsnummer : **0 521 002 B1**

(12)

# EUROPÄISCHE PATENTSCHRIFT

(45) Veröffentlichungstag der Patentschrift :
**24.08.94 Patentblatt 94/34**

(51) Int. Cl.$^5$ : **H03K 17/08**

(21) Anmeldenummer : **91904706.8**

(22) Anmeldetag : **28.02.91**

(86) Internationale Anmeldenummer :
**PCT/DE91/00173**

(87) Internationale Veröffentlichungsnummer :
**WO 91/15058 03.10.91 Gazette 91/23**

(54) **KURZSCHLUSSFESTE TRANSISTORENDSTUFE, INSBESONDERE ZÜNDUNGSENDSTUFE FÜR KRAFTFAHRZEUGE.**

(30) Priorität : **23.03.90 DE 4009304**

(43) Veröffentlichungstag der Anmeldung :
**07.01.93 Patentblatt 93/01**

(45) Bekanntmachung des Hinweises auf die
Patenterteilung :
**24.08.94 Patentblatt 94/34**

(84) Benannte Vertragsstaaten :
**DE FR IT**

(56) Entgegenhaltungen :
**EP-A- 0 032 985**
**EP-A- 0 244 633**
**DE-A- 1 763 889**
**DE-A- 3 928 225**
**FR-A- 2 220 112**
**GB-A- 2 075 297**
**US-A- 4 477 747**

(73) Patentinhaber : **ROBERT BOSCH GMBH**
**Postfach 30 02 20**
**D-70442 Stuttgart (DE)**

(72) Erfinder : **MEINDERS, Horst**
**Kammweg 54**
**D-7410 Reutlingen (DE)**

EP 0 521 002 B1

## Beschreibung

Die Erfindung betrifft eine kurzschlußfeste Transistorendstufe, insbesondere Zündungsendstufe für Kraftfahrzeuge, mit einem in Reihe zu einem Verbraucher geschalteten Leistungstransistor und mit einer Sperrvorrichtung zum Ausschalten des Leistungstransistors im Falle eines Kurzschlusses im Verbraucher.

In Zündanlagen für Kraftfahrzeuge wird zur Erzeugung eines Zündfunkens ein Zündtransformator (Zündspule) mit einem Leistungs-Darlington ein- und ausgeschaltet. Dieser im Primärkreis der Zündspule geschaltete Leistungs-Darlington schaltet Spulenströme zwischen 5 und 15 Ampere. Durch Salzwasser, Schmutz, Hochspannungseinschläge oder Übertemperatur kann der Zündtransformator in seltenen Fällen beschädigt werden, so daß ein primärseitiger Kurzschluß entsteht. Hierbei treten bedingt durch die Batteriespannung, die Sättigungsspannung des Transistors und Kabelwiderstände Ströme zwischen 20 und 30 Ampere auf, welche die Endstufe des Leistungs-Darlington und somit die Zündanlage zerstören.

Um eine derartige Zerstörung im Kurzschlußfall zu verhindern, ist es bekannt, bei Überschreiten einer oberen Stromschwelle die Endstufe stromlos zu schalten.

Die bekannte Anordnung hat jedoch den Nachteil, daß der Leistungs-Darlington trotz Kurschluß der Zündspule bei Unterschreiten dieser Stromschwelle immer wieder einschaltet. Da dieser Schaltbetrieb bei sehr hohen Strömen und auch hohen Frequenzen auftritt, kann die Endstufe trotzdem beschädigt werden.

Aus der US-A 4 477 747 ist eine Transistorendstufe bekannt, welche einen zur Emitter-Kollektor-Strecke in Reihe liegenden Verbraucher ansteuert. Hierbei dient ein zweiter Transistor zur Ermittlung des Kurzschlusses, indem ein Spannungsabgriff zwischen Verbraucher und Kollektor der Transistorendstufe an den Basiseingang des zweiten Transistors geführt ist, so daß im Kurzschlußfall der zweite Transistor die Transistorendstufe sperrt.

Vorteile der Erfindung

Die erfindungsgemäße Transistorendstufe mit den kennzeichnenden Merkmalen des Anspruchs 1 hat den Vorteil, daß der Leistungstransistor nur bei gleichzeitig vorliegendem Kurzschluß im Verbraucher und Ansteuersignal für den Leistungstransistor ausschaltende UND-Verknüpfung vorgesehen, wobei sich diese erfindungsgemäße Transistorendstufe gut zur monolithischen Integration eignet. Zum sicheren Einschalten des Leistungstransistors ist seine Basis über einen niederohmigen Widerstand von weniger als 200 Ohm, vorzugsweise 1 - 2 Ohm, mit dem ersten Schalttransistor verbunden. Hierdurch ist ein weiches Schalten möglich, und der Darlington kann trotz des eingeschalteten ersten Schalttransistors aufgesteuert werden, weil der Verbraucher sofort einen "Nichtkurzschluß" signalisiert und der erste Schalttransistor dadurch gesperrt wird.

Durch die in den abhängigen Ansprüchen aufgeführten Maßnahmen sind vorteilhafte Weiterbildungen und Verbesserungen der im Anspruch 1 angegebenen Transistorendstufe möglich.

Eine besonders einfache Anordnung ergibt sich dann, wenn der im Kurschlußfall stromleitende erste Schalttransistor von wenigstens einem zweiten Schalttransistor steuerbar ist, dessen Steuerseite von wenigstens einem Teil des Spannungsabfalls am Verbraucher beaufschlagt ist. Liegt der Verbraucher mit einem Anschluß am positiven Pol einer Versorgungsspannungsquelle, so kann zweckmäßigerweise wenigstens ein Teil des am Verbraucher abgegriffenen Spannungsabfalls an die Emitter-Basis-Strecke des als pnp-Transistor ausgebildeten zweiten, im Kurzschlußfall gesperrten Schalttransistors angelegt werden.

Eine vorteilhafte Lösung besteht darin, daß die Basis-Emitter-Strecke des zweiten Schalttransistors zum Verbraucher geschaltet ist. Dies ermöglicht eine besonders einfache monolithische Integration der Endstufe, indem der Kollektor des Leistungstransistors an der n-Basis dieses zweiten, als lateraler pnp-Transistor ausgebildeten Schalttransistors liegt. Die n-Basis dieses Schalttransistors stimmt also mit dem Substrat und damit mit dem Kollektor des Leistungstransistors überein. Die Integration ist in $\pi$-n-$\pi$- Technik darstellbar.

Um den Durchstrom zu begrenzen, wird hier zusätzlich neben einem Kollektorwiderstand noch ein Emitterwiderstand vorgesehen. Der gesamte Spannungsabfall am Verbraucher kann zum Aufsteuern des zweiten Schalttransistors verwendet werden, und ein zusätzlicher Spannungsabfall am Emitterwiderstand ist für dieses Aufsteuern unschädlich.

Wegen der geringen Stromverstärkung des zweiten Schalttransistors, insbesondere in der Ausführung ohne Spannungsteiler, ist der Kollektor dieses zweiten Schalttransistors mit einem durch den Kollektorstrom aufsteuerbaren dritten Schalttransistor verbunden, der im aufgesteuerten, stromleitenden Zustand den ersten Schalttransistor sperrt. Hierdurch ist ein sicheres Abschalten des ersten Schalttransistors gewährleistet.

Der Leistungstransistor ist zweckmäßigerweise als npn-Darlington-Transistor ausgebildet, der sich insbesondere zur Ansteuerung einer Primärwicklung einer Zündspule als Verbraucher.

Zeichnung

Ausführungsbeispiele der Erfindung sind in der Zeichnung dargestellt und in der nachfolgenden Beschreibung näher erläutert. Es zeigen:

Fig. 1    ein Schaltbild eines ersten Ausführungsbeispiels einer kurzschlußfesten Transistorendstufe mit einem Spannungsteiler parallel zur Primärwicklung einer Zündspule,

Fig. 2    das Schaltbild eines zweiten Ausführungsbeispiels ohne einen solchen Spannungsteiler,

Fig. 3    die Darstellung der Diffusionszonen des als vertikaler npn-Schalttransistor ausgebildeten ersten und dritten Schalttransistors,

Fig. 4    die Diffusionszone des als vertikaler pnp-Schalttransistor ausgebildeten zweiten Schalttransistors gemäß Fig. 1,

Fig. 5    die Diffusionszonen des als lateraler pnp-Schalttransistor ausgebildeten zweiten Schalttransistors gemäß Fig. 2,

Fig. 6    das Schaltbild eines Ausführungsbeispiels der Erfindung und

Fig. 7    die Diffusionszonen gemäß dem Ausführungsbeispiel nach Figur 6.

Beschreibung der Ausführungsbeispiele

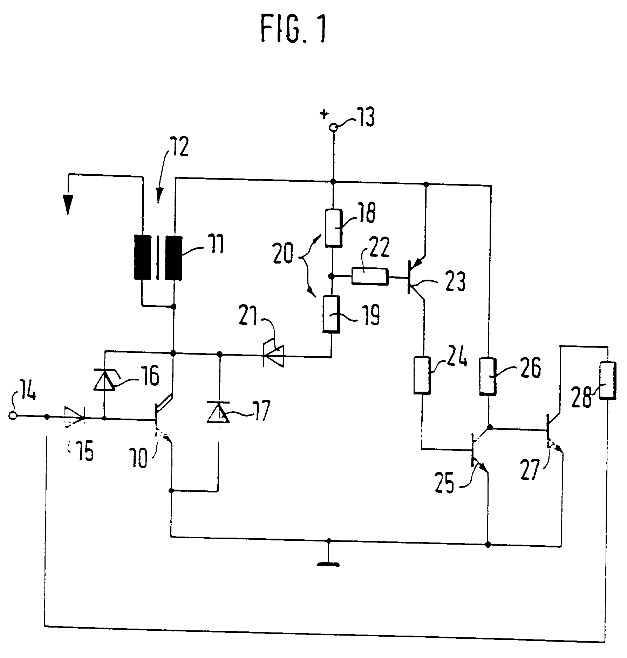

Bei dem in Fig. 1 dargestellten ersten Ausführungsbeispiel ist die Schaltstrecke eines npn-Leistungs-Darlington 10 (im folgenden Leistungstransistor bezeichnet) in Reihe zu einer Primärwicklung 11 einer Zündspule 12 geschaltet, wie sie in üblicher Weise im Kraftfahrzeug zur Erzeugung von Zündfunken in Brennräumen verwendet wird. Der Emitter des Leistungstransistors 10 liegt dabei an Masse, während der vom Leistungstransistor 10 abgewandte Anschluß der Primärwicklung 11 mit dem positiven Anschluß 13 einer Versorgungsspannungsquelle verbunden ist, die im Falle eines Kraftfahrzeugs als Batterie ausgebildet ist. Ein Steuereingang 14 der insgesamt dargestellten kurzschlußfesten Transistorendstufe ist über eine Entkoppel-Diode 15 mit der Basis des Leistungstransistors 10 verbunden, die über eine Klammer-Z-Diode 16 am Kollektor des Leistungstransistors 10 angeschlossen ist. Weiterhin ist die Schaltstrecke des Leistungstransistors 10 durch eine Freilauf-Diode-17 überbrückt.

Parallel zur Primärwicklung 11 ist die Reihenschaltung eines aus zwei Teilerwiderständen 18,19 bestehenden Spannungsteilers 20 mit einer hochsperrenden Schutz-Z-Diode 21 geschaltet. Der Abgriff des Spannungsteilers 21 ist über einen Temperaturkompensationswiderstand 22 mit der Basis eines zweiten pnp-Schalttransistors 23 verbunden, dessen Emitter dem positiven Anschluß 13 und dessen Kollektor über einen Kollektorwiderstand 24 mit der Basis des dritten npn-Schalttransistors 25 verbunden ist. Der Emitter dieses dritten Schalttransistors 25 liegt an Masse, während der Kollektor sowohl über einen Widerstand 26 mit dem positiven Anschluß 13 als auch direkt mit der Basis eines ersten npn-Schalttransistors 27 verbunden ist. Der Emitter dieses ersten Schalttransistors 27 liegt an Masse, und der Kollektor ist über einen Widerstand 28 am Steuereingang 14 angeschlossen.

Die Wirkungsweise der in Fig. 1 dargestellten kurzschlußfesten Transistorendstufe besteht im wesentlichen darin, daß bei nicht kurzgeschlossener Zündspule der Spannungsabfall an der Primärwicklung 11 am Spannungsteiler 20 anliegt, wodurch der zweite Schalttransistor 23 aufgesteuert ist, also leitet. Hierdurch fließt ein Kollektorstrom zum dritten Schalttransistor 25, wodurch dieser ebenfalls aufgesteuert ist. Hierdurch ist wiederum die Emitter-Basis-Strecke des ersten Schalttransistors 27 kurzgeschlossen, und dieser sperrt. Der Leistungstransistor 10 kann dadurch unbeeinträchtigt von der durch die Bauteile 18-28 gebildeten Sperrvorrichtung über den Steuereingang 14 zur Erzeugung von Zündfunken gesteuert werden.

Im Kurzschlußfall liegt am Spannungsteiler 20 keine oder nur noch eine sehr geringe Spannung an, wodurch der zweite Schalttransistor 23 sperrt und den dritten Schalttransistor 25 ebenfalls in den gesperrten Zustand überführt. Hierdurch wird der erste Schalttransistor 27 über den Widerstand 26 stromleitend abgeschaltet, so daß die Basis des Leistungstransistors 10 über den niederohmigen Widerstand 28 und die Schaltstrecke des ersten Schalttransistors 27 kurzgeschlossen wird. Der Leistungstransistor 10 wird dadurch gesperrt und bleibt gesperrt. Der in der Spule fließende Strom wird nun langsam im Laufe von 10 - 15 ms abgebaut, wobei sich dieser langsame Stromabfall nicht schädlich auf das Zündverhalten auswirken kann. weil hierbei kein Zündfunken mehr erzeugt wird. Das einwandfreie Funktionieren der Kurzschlußabschaltung muß in allen Schaltzuständen des Leistungstransistors 10 sichergestellt sein. Folgende Schaltzustände der Transistorendstufen sind dabei möglich:

1. Leistungstransistor ausgeschaltet.

In diesem Schaltzustand liegt die Versorgungsspannung am Kollektor des Leistungstransistors 10 an, wodurch an der Primärwicklung 11 keine Spannung abfällt. Die Schalttransistoren 23 und 25 sind stromlos, und der erste Schalttransistor 27 ist stromleitend. Durch ein weiches Schalten über den niederohmigen Widerstand 28, der weniger als 200 Ohm und vorzugsweise 1 - 2 Ohm aufweist, ist es möglich, den Leistungstransistor 10 trotz stromleitenden Schalttransistors 27 aufzusteuern, weil die Zündspule sehr schnell einen "Nichtkurzschluß" signalisiert und den Schalttransistor 27 über die beiden anderen Schalttransistoren 23 und 25 sperrt.

2. Leistungstransistor eingeschaltet und in der Sättigung.

Beim Einschalten des Leistungstransistors 10 fällt an der Primärwicklung 11 die Spannung $R_z \cdot I_c + L_z \cdot |dI_c/dt|$ ab. Dabei ist $R_z$ der Widerstand der Primärwicklung, $L_z$ die Spuleninduktivität und $I_c$ der Kollektorstrom des Leistungstransistors. Der Spannungsabfall an der Primärwicklung 11 beträgt in dieser Phase 11 bis 12 Volt. Durch die Gegeninduktivität wird die Kollektor-Emitter-Spannung des Leistungstransistors auf niedrige Werte (Sättigungsspannung) gedrückt. Werden die beiden Teilerwiderstände beispielsweise auf je 1 kOhm eingestellt, so wird der Teilerwiderstand 18 durch die Emitter-Basis-Strecke des Schalttransistors 23 kurzgeschlossen, und der Querstrom des Spannungsteilers 20 wird nur durch den Widerstand 19 (bei Vernachlässigung des Widerstand 22) bestimmt. Mit ca. 10 mA trit durch ihn keine wesentliche Veränderung des Spulenstroms auf.

3. Leistungstransistor eingeschaltet, im aktiven Betrieb.

Nach ca. 5 ms liegt an der Primärwicklung 11 nur noch die Spannung $R_z \cdot I_c$ an, weil die Gegeninduktionsspannung abgeklungen ist. Die Kollektor-Emitter-Spannung des Leistungstransistors steigt somit auf Werte von 8 bis 9 Volt an, und er befindet sich im aktiven Betrieb. Auch bei diesem rein ohmschen Spannungsabfall ist bei einem Teilerverhältnis von ungefähr 1 : 1 sichergestellt, daß die Schalttransistoren 23 und 25 eingeschaltet sind, wenn die Primärwicklung nicht kurzgeschlossen ist. Die Schaltung bietet jedoch bei geeigneter Dimensionierung des Spannungsteilers 20 und Wahl verschiedener Widerstandsmaterialien für die Teilerwiderstände 18 und 19 zusätzlich die Möglichkeit, den Leistungstransistor vor zu langem Betrieb im aktiven Bereich mit den damit verbundenen hohen Einschaltverlusten zu schützen. Zur Erreichung eines temperaturstabilen Abschaltstroms dient der Temperaturkompensationswiderstand 22, der den negativen Temperaturgang der Emitter-Basis-Spannung des Schalttransistors 23 kompensiert.

4. Abschaltphase (Kollektor des Leistungstransistors auf hoher Spannung).

Beim Abschalten des Kollektorstroms treten je nach auslegung am Kollektor des Leistungstransistors 10 Spannungen bis zu 400 Volt auf. Die Z-Diode 21 mit einem Sperrvermögen von über 400 Volt koppelt im Klammerfall die Sperrvorrichtung mit den drei Schalttransistoren vom Kollektorpotential des Leistungstransistors ab. Im Klammerbetrieb sind die Schalttransistoren 23 und 25 gesperrt, während der Schalttransistor 27 eingeschaltet ist. Die Basis des Leistungstransistors wird somit bei jedem Abschaltvorgang über den Widerstand 28 ausgeschaltet. Die zur Spannungsbegrenzung des Leistungstransistors eingesetzte Klammer-Z-Diode 16 wird nicht zusammen mit der zum Kollektor des Schalttransistors 27 führenden Leitung an der Basis des Leistungstransistors 10 angeschlossen. Erfolgt die Klammerung extern, das heißt über eine im separaten Ansteuerschaltkreis vorhandene Z-Diode, die mit Hilfe eines Klammerteilers hochtransformiert wird, dann wird der Ansteuerpunkt mit Hilfe der Entkoppel-Diode 15 vom Klammerkreis entkoppelt.

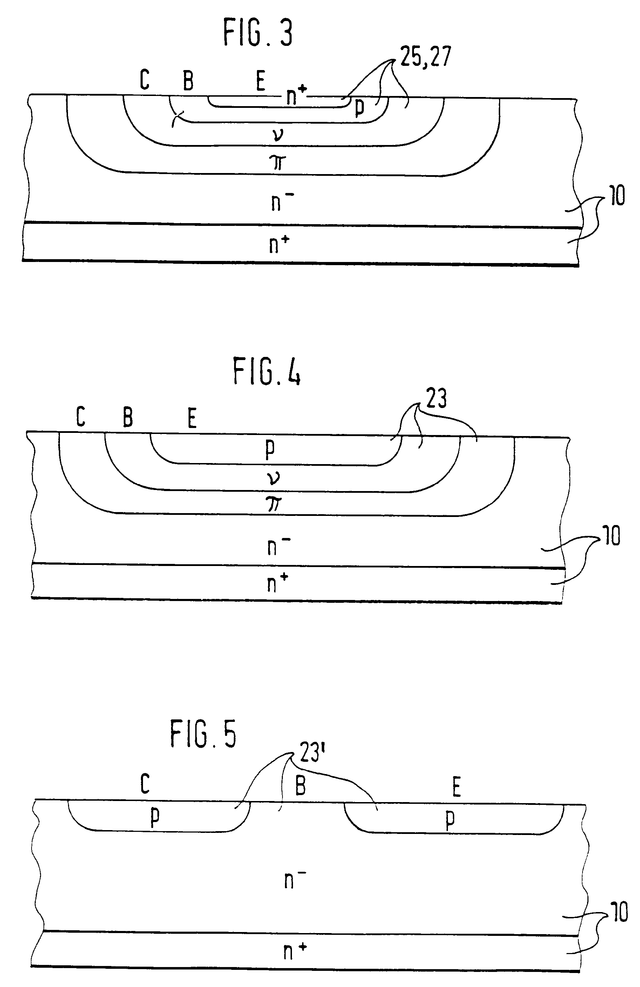

Die gesamte Transistorendstufe wird vorzugsweise als monolithisch integrierter Schaltkreis ausgeführt. In Fig. 3 sind die Diffusionszonen der npn-Schalttransistoren 25 und 27 dargestellt. Der Emitter (E) dieser Schalttransistoren besteht aus einer $n^+$-Schicht, die Basis (B) aus einer p-Schicht und der Kollektor aus einer $\nu$-Schicht. Bei diesen vertikalen npn-Schalttransistoren erfolgt die Potentialtrennung zum Potential des Leistungstransistors 10 (untere $n^-$- und $n^+$-Schichten) über die zusätzliche Zone $\pi$, die schwach p-dotiert ist. Auch die schwach n-dotierte $\nu$-Schicht trägt zur Potentialtrennung bei. Da an den Kollektoren der Schalttransistoren 25 und 27 nur maximal 2 bis 3 Volt anliegen, ist die Gefahr eines parasitären Thyristor-Zündens (Latching) nicht gegeben.

Beim vertikalen pnp-Schalttransistor 23, der in Fig. 4 dargestellt ist, trifft dieses Argument nicht zu. Da hier der Emitter mit dem positiven Anschluß 13 der Versorgungsspannungsquelle (14 Volt) verbunden ist, kann ein Latching der p-, $\nu$-, $\pi$-, $n^-$-Schichten auftreten, wenn der Kollektor des Darlington in der Sättigung (2 Volt) liegt. Da kein strombegrenzender Widerstand vorhanden ist, kann dieses Latching zur Zerstörung des Schalttransistors 27 führen. Dieses Latching läßt sich durch eine Verschlechterung der Neigung zum Thyristor-Zünden durch Bildung eines "shorted emitter" zwischen der p- und der $\nu$-Schicht vermeiden. Im übrigen liegt auch hier eine schwach p-dotierte $\pi$-Schicht vor.

Die Teilerwiderstände 18 und 19 werden in nicht dargestellter Weise durch verschieden dotierte p-Materialien gebildet, wodurch der positive Temperaturgang des Kupferspulenwiderstandes der Primärwicklung 11 kompensiert werden kann. Das Teilerverhältnis des Spannungsteilers 20 erhält einen solchen Temperaturgang, daß es mit dem Temperaturgang des Kupferwiderstandes der Primärwicklung 11 übereinstimmt, so daß die Schaltschwelle zum Abschalten des Zündspulenstroms temperaturkonstant ist.

Die Schaltung kann als Stromregelschaltung verwendet werden. Hierzu wird der Spannungsteiler so ausgelegt, daß der Leistungstransistor nach Abklingen der Induktionsspannung beim Regelstrom $I_R$ eingeregelt wird. Dieser Regelstrom kann gemäß der folgenden Bedingung gewählt werden:

$$R_z \cdot I_R \cdot R_1 / (R_1 + R_2) = 0,7 \, V = S$$

Dabei ist S die Schaltschwelle des pnp-Transistors, $R_Z$ der Spulenwiderstand, $R_1$ der Teilerwiderstand 18 und $R_2$ der Teilerwiderstand 19.

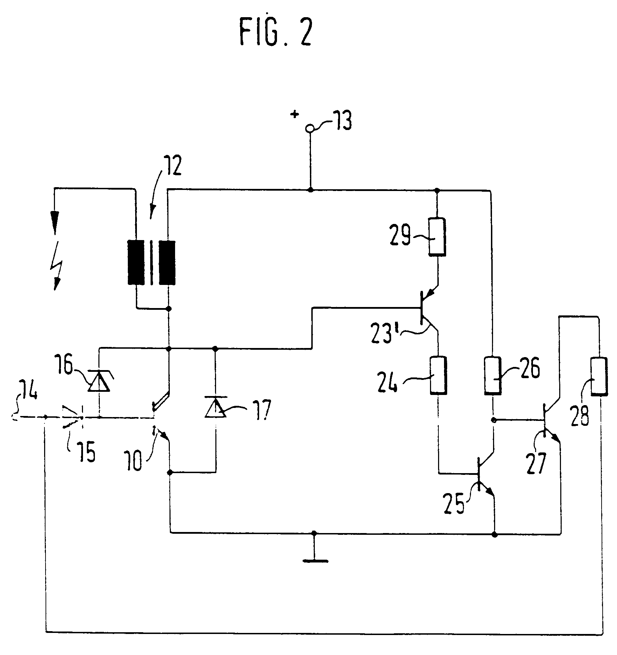

Das in Fig. 2 dargestellte zweite Ausführungsbeispiel einer Transistorendstufe entspricht weitgehend dem ersten Ausführungsbeispiel, wobei gleiche oder gleich wirkende Bauteile mit denselben Bezugszeichen versehen und nicht nochmals beschrieben sind.

Der Spannungsteiler 20, der Temperaturkompensationswiderstand 22 und die Z-Diode 21 entfallen. Anstelle des zweiten Schalttransistors 23, der als vertikaler pnp-Schalttransistor ausgebildet ist, tritt nunmehr ein lateraler pnp-Schalttransistor 23', wie er in Fig. 5 dargestellt ist. Im Klammerfall muß die Basis dieses Schalttransistors 23' die hohe Spannung vom Leistungstransistor 10 sowohl zum Emitter als auch zum Kollektor sperren können. Deswegen dürfen die beiden p-Wannen des Emitters (E) und des Kollektors (C) nicht zu nahe aneinandergebracht werden. Um trotzdem den Druchbruchstrom zu begrenzen, ist zusätzlich zum Kollektorwiderstand 24 noch ein Emitterwiderstand 29 zwischen dem Emitter und dem Anschluß 13 vorgesehen. Wegen des fehlenden Spannungsteilers kann hier der gesamte Spannungsabfall an der Primärwicklung 11 zum Aufsteuern des Schalttransistors 23 verwendet werden, wobei ein zusätzlicher Spannungsabfall am Emitterwiderstand 29 unschädlich ist. Da der laterale Schalttransistor 23' eine sehr geringe Stromverstärkung (1-5) aufweist, muß der Schalttransistor 25 mit dem geringen, vom Schalttransistor 23' kommenden Basisstrom (1-2 mA) schon durchgesteuert werden können. Hierzu ist eine Stromverstärkung von 50-60 erforderlich, um eine sicheres Abschalten des Schalttransistors 27 zu gewährleisten.

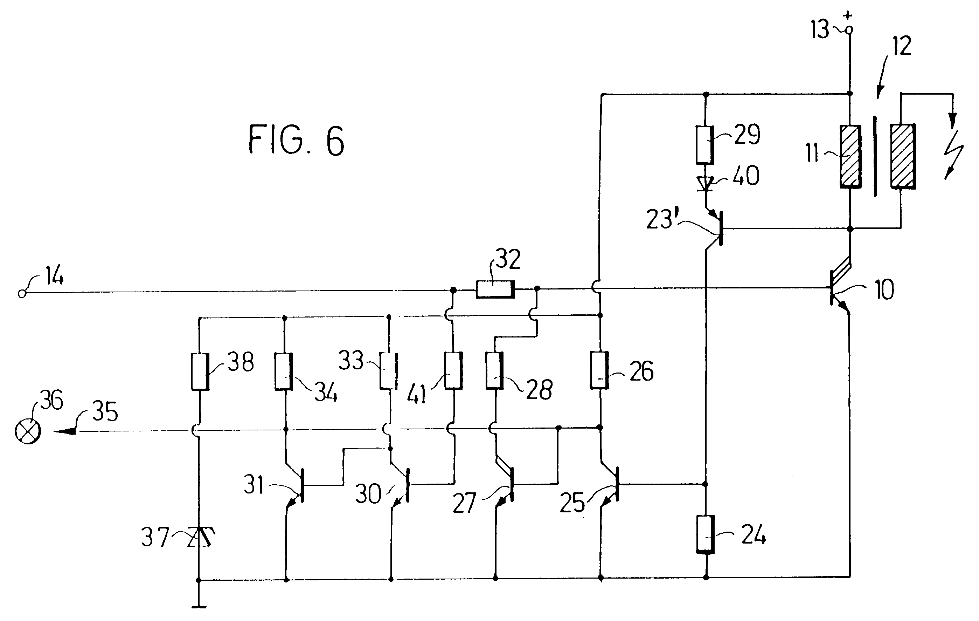

Das in Fig. 6 dargestellte Ausführungsbeispiel der Erfindung entspricht in seinem prinzipiellen Aufbau dem zweiten Ausführungsbeispiel, wobei gleiche oder gleich wirkende Bauteile mit denselben Bezugszeichen versehen und nicht nochmals detailliert beschrieben sind. Im Unterschied zum zweiten Ausführungsbeispiel ist nunmehr der Kollektor des zweiten, wiederum als lateraler pnp-Schalttransistor ausgebildeten Transistors 23' direkt mit der Basis des dritten Schalttransistors 25 verbunden, während der Kollektorwiderstand 24 nunmehr zwischen dem Kollektor des Schalttransistors 23' und Masse geschaltet ist. Er besitzt einen typischen Wert von 100 Ohm. Die Diode 15 entfällt, ebenso wie die Dioden 16, 17, wobei letztere bei Bedarf selbstverständlich auch hier eingesetzt werden können. Zusätzlich ist eine Schutzdiode 40 zwischen den Emitter des Schalttransistors 23' und den Emitterwiderstand 29 geschaltet.

Zur Herstellung einer logischen UND-Verknüpfung für das Vorliegen eines Spulenkurzschlusses und eines positiven Ansteuersignals am Steuereingang 14 sind eine vierter Schalttransistor 30 und eine fünfter Schalttransistor 31 vorgesehen. Die Basis des vierten Schalttransistors 30 ist über einen Vorwiderstand 41 von z.B. 2 KOhm mit dem Steuereingang 14 verbunden, der nunmehr über einen Basiseingangswiderstand 32 mit der Basis des Leistungstransistors 10 verbunden ist. Die Emitter der beiden Schalttransistoren 30,31 liegen an Masse, und die beiden Kollektoren sind über je einen Widerstand 33,34 mit dem positiven Anschluß 13 der Spannungsquelle verbunden. Weiterhin ist der Kollektor des Schalttransistors 30 mit der Basis des Schalttransistors 31 verbunden, dessen Kollektor wiederum sowohl an den Kollektor des Schalttransistors 25 als auch an einen Steuerausgang 35 angeschlossen ist, der zur Steuerung einer Kontrolleuchte 36 dient. Schließlich ist die Reihenschaltung einer Z-Diode 37 mit einem Widerstand 38 parallel zur Spannungsquelle gelegt.

Auch bei diesem Ausführungsbeispiel wird wiederum der zweite Schalttransistor 23' immer dann durchgesteuert, wenn sich an der Primärwicklung 11 eine so gerichtete Spannung aufbaut, daß der Kollektor des Leistungstransistors 10 auf einer negativeren Spannung als die positive Versorgungsspannung der Zündspule 12 ist. Diese Spannung zur Durchsteuerung des Schalttransistors 23' entsteht genau dann, wenn die Zündspule 12 in Ordnung ist und der Darlington eingeschaltet wird. Der Spannungsabfall an der Primärwicklung 11 setzt sich aus dem rein ohmschen Spulenanteil $I \cdot R_L$ und überwiegend aus dem induktiven Anteil $L \cdot dI/dt$ zusammen. Bei einem typischen Spulenwiderstand von 0.4 Ohm und Strömen über 8 Ampère reicht der Spannungsabfall an der Primärwicklung 11 immer aus, um den Schalttransistor 23' einzuschalten. Der Schalttransistor 25 befindet sich immer im gleichen Schaltzustand wie der Schalttransistor 23'. Bei ausgeschaltetem Schalttransistor 23', also z.B. im Kurzschlußfall, wird die Basis des Schalttransistors 25 über den Kollektorwiderstand 24 sicher gegen Masse gezogen. Der Kollektor des Schalttransistors 25 liegt dann auf plus-Potential. Er hat eine niedrigeres Potential, wenn die Spule in Ordnung ist.

Der Leistungstransistor 10 soll nur im Falle eines Spulenkurzschlusses und gleichzeitigem Vorliegen eines positiven Ansteuersignales am Steuereingang 14 abgeschaltet werden. Die entsprechende logische UND-Verknüpfung zwischen diesen beiden Bedingungen wird durch die Schalttransistoren 30,31 realisiert, die ein kräftiges, logisch verwertbares Signal erzeugen. Das Ansteuersignal vor dem Basiseingangswiderstand 32, der üblicherweise einen Wert von 10-20 Ohm aufweist, wird auf die Basis des Schalttransistors 30 gegeben, dessen Kollektorspannung wiederum zur Signalinvertierung zur Basis des Schalttransistors 31 geführt wird. Somit ist der Kollektor des Schalttransistors 31 mit dem plus-Potential der Versorgungsspannung beaufschlagt, wenn an der Basis des Leistungstransistors 10 ein Ansteuersignal anliegt. Die Kollektoren der Schalttransistoren 25 und 31 sind miteinander verbunden und werden gemeinsam zur Basis des Schalttransistors 27 geführt, der dadurch nur in dem Falle angesteuert wird, wenn beide Kollektoren gleichzeitig auf positivem Potential liegen. Dies ist nur dann der Fall, wenn die Primärwicklung 11 kurzgeschlossen ist und der Leistungstransistor 10 angesteuert wird. Der Schalttransistor 27 leitet dann - wie im vorherigen Ausführungsbeispiel - bei Spulenkurzschluß den Basisstrom des Leistungstransistors 10 ab. Bei Auslegung des Schalttransistors 27 als Einzeltransistor muß der Widerstand 28 als Kollektorwiderstand vorgesehen und gemäß der Bedingung:

$$(R32 + R28) . I_b > 0,7 V$$

dimensioniert sein. Dabei ist $I_b$ der Basisstrom. Bei dieser Dimensionierung findet der Schalttransistor 30 trotz des wirkenden Kurzschlusses des Schalttransistors 27 immer noch ein ausreichendes Ansteuersignal vor. Wenn diese Bedingung nicht erfüllt ist, kann es bei der Stromabschaltung zu Schwingungen kommen. Der Schalttransistor 27 kann auch als Darlington ausgelegt werden. Dann liegt bei ihm im eingeschalteten Zustand eine Sättigungsspannung von etwa 1 Volt vor, die ausreicht, um den Schalttransistor 30 anzusteuern, die aber kleiner als die Basis-Emitter-Spannung des zweistufigen (1,4 Volt) oder dreistufen (2,1 Volt) Darlington ist, der somit sicher ausgeschaltet ist. In diesem Falle kann der Widerstand 28 entfallen.

Die Kontrolleuchte 36 wird bei Sperrung der Schalttransistoren 25,31, also im Kurzschlußfall der Primärwicklung 11, eingeschaltet und zeigt den Kurzschluß an.

In der folgenden Tabelle sind die vier Möglichkeiten dargestellt, bei denen die Kurzschlußsicherung ansprechen bzw. nicht ansprechen soll. Wesentlich ist dabei, daß infolge der beschriebenen UND-Verknüpfung die Kurzschlußsicherung nur im ersten Fall anspricht, nicht dagegen in den Fällen zwei bis vier. Nur im ersten Fall wird auch die Kontrollleuchte 36 eingeschaltet.

| | Kollektor T 25 | Kollektor T 31 | |
|---|---|---|---|
| 1. Spule defekt, Darlington 10 angesteuert | H | H | → T 27 angesteuert |
| 2. Spule defekt, Darlington 10 nicht angesteuert | H | L | → T 27 nicht angesteuert |
| 3. Spule i.O., Darlington 10 angesteuert | L | H | → T 27 nicht angesteuert |
| 4. Spule i.O., Darlington 10 nicht angesteuert | H | L | → T 27 nicht angesteuert |

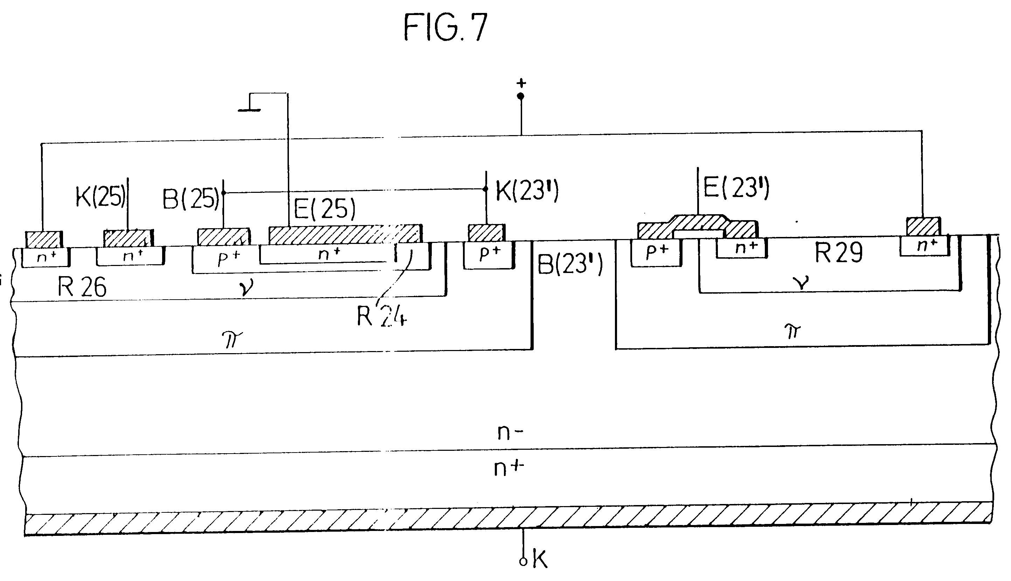

Der Anschluß 13 ist mit dem positiven Pol der Versorgungsspannungsquelle verbunden, also üblicherweise mit der plus-Klemme der Kraftfahrzeugbatterie. Hier können hohe Überspannungen durch das Abschalten von Induktivitäten im Kraftfahrzeug auftreten. Diese Abschaltspitzen können 100 - 150 Volt betragen, und es ist ein Schutz gegen diese Abschaltspitzen erforderlich. Aus diesem Grunde ist die Z-Diode 37 mit einer Durchbruchspannung von über 30 Volt in Reihe mit dem als Strombegrenzungswiderstand dienenden Widerstand 38 parallel zur Spannungsquelle geschaltet. Durch diese Z-Diode 37 werden die Schalttransistoren 25,30,31 gegen solche Überspannungen (load-dump) geschützt. Der Schalttransistor 23′ benötigt diesen Schutz nicht, weil er auf Grund seiner Konstruktion (zwei Basiswannen im Substrat, siehe Fig. 7) von sich aus eine hohe Sperrfähigkeit besitzt.

Die gesamte Schaltung, also der Leistungstransistor, die Schalttransistoren, die Widerstände und die Z-Diode, werden vorzugsweise auch bei diesem Ausführungsbeispiel als monolithisch integrierter Schaltkreis ausgeführt. Dabei wird die monolithische Darstellung des als Darlington ausgebildeten Leistungstransistors mit den zusätzlichen Komponenten Invers-Diode, Emitter-Basis-Widerstände, Z-Diode zur Klammerspannungsbegrenzung u.dgl. als bekannt vorausgesetzt und hier nicht näher erläutert.

In Fig. 7 ist die Integration der Transistoren 23′ und 25 mit den Widerständen 29 und 24 als Ausschnitt des monolithisch integrierten Schaltkreises dargestellt. Das n-Substratmaterial weist auf seiner Rückseite in bekannter Weise das Rückseiten-Diffusionsprofil $n^+$ mit der Kollektoranschluß-Metallisierung auf. Dieses Substrat liegt also auf dem Potential des Leistungs-Darlington. Um dieses Potential von dem Potential der Schalttransistoren zu trennen, wurden isolierende ν- und π-Diffusionszonen zwischen das Substrat und den $p^+$- und $n^+$-Schichten der Schalttransistoren geschoben. Die Konzentrationen der ν- und π-Zonen sind so gewählt, daß sie gegeneinander eine Sperrfähigkeit von über 100 Volt aufweisen. Somit sind bei allen Einschaltvorgängen die Potentiale des Leistungs-Darlingtons und der Schalttransistoren gut voneinander getrennt.

Der Emitter (E) und der Kollektor (C) des pnp-Transistors 23′ werden durch die beiden π-Wannen dargestellt. Die Basis ist identisch mit dem Kollektor des Leistungs-Darlingtons. Der strombegrenzende Emitterwiderstand 29 besteht aus ν-Material und besitzt typische Werte von 100 Ohm, die mit dem Quadratwiderstand von 100 - 200 Ohm/square leicht darstellbar sind. Die $p^+$- bzw. $n^+$-Aufdiffusionen an den Kontaktfenstern sollen hier nur für einen guten ohmschen Anschluß der ν- bzw. π-Zonen sorgen. Der npn-Transistor 25 (linker Teil in Fig. 7) besteht aus der vertikalen Struktur: $n^+$ (Emitter), $p^+$ (Basis) und ν (Kollektor), der wieder mit der $n^+$-Anschlußdiffusion versehen ist. Hier ist der Emitter-Basis-Widerstand 24 aus $p^+$-Material dargestellt. Mit dem $p^+$-Quadratwiderstand von 50 Ohm/square lassen sich Widerstände von 100 - 200 Ohm gut realisieren.

In Fig. 7 ist weiterhin der Kollektorwiderstand 26 dargestellt. Er hat typische Werte von 1 - 5 kOhm und läßt sich ebenfalls mit ν-Material ohne allzugroßen Platzaufwand darstellen.

Die Integration der übrigen Schalttransistoren 27,30 und 31 mit ihren Widerständen erfolgt in analoger Weise und wird daher nicht nochmals detailliert dargestellt. Die Schutz-Z-Diode 37 kann als $p^+$- ν-Diode oder zur Vergrößerung der Z-Spannung als $p^+$- -Diodenkette dargestellt werden. Auch hier wird der Widerstand 38 gemäß dem Widerstand 29 aus ν-Material erzeugt.

Das Ausführungsbeispiel zeit einen npn-Leistungs-Darlington in Verbindung mit einer Zündspule. In Abwandlung hiervon kann auch ein beliebiger anderer Verbraucher treten, der von einer derartigen kurzschlußfesten Transistorendstufe angesteuert wird, wobei anstelle eines Leistungs-Darlingtons auch prinzipiell ein anderer Leistungstransistor treten kann, der auch als pnp-Transistor ausgebildet sein kann.


**Patentansprüche**

1. Transistorendstufe, insbesondere eine mit der Primärwicklung (11) einer Zündspule (12) in Reihe geschaltete Zündendstufe, die zur Erfassung des Spannungsabfalls in einem durch einen Leistungstransistor (10) der Transistorendstufe zu schaltenden Verbraucher (11) eine Basis-Emitter-Strecke eines zweiten Schalttransistors (23′) aufweist, wobei bei einem Spannungsabfall im Verbraucher (11) unterhalb eines vorgebbaren, sehr kleinen, den Kurzschlußfall definierenden Spannungsabfalls der Stromfluß durch den Leistungstransistor (10) unterbunden ist, dadurch gekennzeichnet, daß der Emitter des zweiten Schalttransistors (23′) einen Emitterwiderstand (29) aufweist und der Kollektor des zweiten Schalttransistors (23′) mit einem durch den Kollektorstrom aufsteuerbaren dritten Schalttransistor (25) verbunden ist, dessen Kollektor zum einen über einen Strombegrenzungswiderstand (26) mit dem positiven Pol einer Versorgungsspannungsquelle (13) und zum anderen mit dem Basiseingang eines ersten Schalttransistors (27) verbunden ist, wobei der Kollektor des ersten Schalttransistors (27) mit der Basis des Leistungstransistors (10) verbunden ist, um den Basisstrom des Leistungstransistors (10) zu verringern, wobei der dritte Schalttransistor (25) im aufgesteuerten stromleitenden Zustand den ersten Schalttransistor (27) sperrt und daß der Leistungstransistor (10) einen Basiseingangswiderstand (32) aufweist, dessen eingangsseitiger Anschluß mit einem Steuereingang (14) verbunden ist und über einen Widerstand (41) einen vierten, zur Invertierung des am Steuereingang (14) anliegenden Ansteuersignals dienenden Schalttransistor (30) ansteuert, welchem ein fünfter Schalttransistor (31) nachgeschaltet ist, dessen Basis über einen Widerstand (33) mit dem positiven Pol der Versorgungsspannungsquelle (13) verbunden ist und dessen Kollektor mit dem Basis eingang des ersten Schalttransistors (27) verbunden ist, so daß der fünfte Schalttransistor (31) bei fehlendem Ansteuersignal für den Leistungstransistor (10) den ersten Schalttransistor (27) sperrt.

2.  Transistorendstufe nach Anspruch 1, dadurch gekennzeichnet, daß in einer monolithisch integrierten Ausführung der Kollektor des Leistungstransistors (10) an der n-Basis des zweiten, als lateraler pnp-Transistor ausgebildeten Schalttransistors (23′) liegt.

3.  Transistorendstufe nach Anspruch 1 und 2, dadurch gekennzeichnet, daß die Emitter-Basis-Strecke des ersten als npn-Transistor ausgebildeten Schalttransistors (27) durch den dritten Schalttransistor (25) überbrückbar ist.

4.  Transistorendsstufe nach einem der vorhergehenden Ansprüche, dadurch gekennzeichnet, daß die Basis des Leistungstransistors (10) über einen niederohmigen Widerstand (28) von weniger als 200 Ohm mit dem Kollektor des ersten Schalttransistor (27) verbunden ist.

5.  Transistorendstufe nach einem der vorhergehenden Ansprüche, dadurch gekennzeichnet, daß der Kollektor des dritten Schalttransistors (25) als Steuerausgang für ein Kontrollelement (36) wie eine Kontrolleuchte, vorgesehen ist.

6.  Transistorendstufe nach einem der vorhergehenden Ansprüche, dadurch gekennzeichnet, daß in Reihe zum zweiten Schalttransistor (23′) ein Kollektorwiderstand (24) vorgesehen ist.

7.  Transistorendstufe nach einem der vorhergehenden Ansprüche, gekennzeichnet durch vollständige Ausbildung als monolithisch integrierter Schaltkreis.

8.  Transistorendstufe nach Anspruch 7, dadurch gekennzeichnet, daß zur Erzeugung der Basis- und Emitter-Schichten wenigstens eines Teils der Schalttransistoren (23′, 27, 25) je eine zusätzliche tiefer liegende $\nu$-und $\pi$-Schicht zur Isolation der Potentiale vorgesehen ist.

9.  Transistorendstufe nach Anspruch 8, dadurch gekennzeichnet, daß der zweite laterale pnp-Transistor (23′) mit den Schichten $\pi$, $n^-$, $\pi$ aufgebaut ist, wobei die Basis gleichzeitig der Kollektor des Leistungstransistors (10) ist.

10.  Transistorendstufe nach Anspruch 9, dadurch gekennzeichnet, daß der Emitterwiderstand (29) des zweiten Schalttransistors (23′) aus $\nu$-Material besteht.

11.  Transistorendstufe nach einem der vorhergehenden Ansprüche, dadurch gekennzeichnet, daß die npn-Schalttransistoren (25, 27, 30, 31) aus vertikalen $n^+$-, $p^+$- und $\nu$-Schichten bestehen, die über hochohmige $\pi$-Isolationswannen vom Kollektorpotential des Leistungstransistors getrennt sind.

12.  Transistorendstufe nach einem der vorhergehenden Ansprüche, dadurch gekennzeichnet, daß die Kollektorwiderstände (26, 28, 33, 34) der npn-Schalttransistoren (25, 27, 30, 31) aus $\nu$-Material bestehen, während der Emitter-Basis-Widerstand (24) des dritten Schalttransistors (25) aus $p^+$-Material besteht.

13.  Transistorendstufe nach einem der vorhergehenden Ansprüche, dadurch gekennzeichnet, daß eine aus der Reihenschaltung einer Z-Diode (37) mit einem Strombegrenzungswiderstand (38) bestehende Überspannungsschutzvorrichtung an die Versorgungsspannungsquelle gelegt ist.

14.  Transistorendstufe nach Anspruch 13, dadurch gekennzeichnet, daß die Z-Diode (37) aus wenigstens einer $p^+$-$\nu$-Schichtenfolge besteht.

## Claims

1.  Transistor output stage, especially an ignition output stage, which is connected in series with the primary winding (11) of an ignition coil (12) and, for the purpose of detecting the voltage drop in a load (11) to be switched by a power transistor (10) of the transistor output stage (9), has a base-emitter junction of a second switching transistor (23′), the current flow through the power transistor (10) being suppressed in the case of a voltage drop in the load (11) below a prescribable, very small voltage drop which defines the occurrence of a short circuit, characterised in that the emitter of the second switching transistor (23') has an emitter resistor (29) and the collector of the second switching transistor (23') is connected to a third switching transistor (25), which can be turned on by the collector current and whose collector is connected, on the one hand, to the positive pole of a supply voltage source (13) via a current-limiting resistor (26) and, on the other hand, to the base input of a first switching transistor (27), the collector of the first switching transistor (27) being connected to the base of the power transistor (10), in order to reduce the base current of the power transistor (10), the third switching transistor (25) blocking the first switching transistor (27) in the turned-on current-conducting state, and in that the power transistor (10) has a base input resistor (32) whose input-side terminal is connected to a control input (14) and drives, via a resistor (41), a fourth switching transistor (30) serving to invert the drive signal applied to the drive input (14), downstream of which there is connected a fifth switching transistor (31) whose base is connected via a resistor (33) to the positive pole of the supply voltage source (13) and whose collector is connected to the base input of the first switching transistor (27) so that the fifth switching transistor (31) blocks the first switching transistor (27) in the event of a missing drive signal for the power transistor (10).

2. Transistor output stage according to Claim 1, characterised in that in a monolithically integrated version the collector of the power transistor (10) is conected to the n-base of the second switching transistor (23'), which is constructed as a lateral pnp transistor.

3. Transistor output stage according to Claims 1 and 2, characterised in that the emitter-base junction of the first switching transistor (27), which is constructed as an npn transistor, can be bridged by the third switching transistor (25).

4. Transistor output stage according to one of the preceding claims, characterised in that the base of the power transistor (10) is connected via a low-resistance resistor (28) of less than 200 ohms to the collector of the first switching transistor (27).

5. Transistor output stage according to one of the preceding claims, characterised in that the collector of the third switching transistor (25) is provided as a control output for a control element (36) such as a control lamp.

6. Transistor output stage according to one of the preceding claims, characterised in that a collector resistor (24) is provided in series with the second switching transistor (23').

7. Transistor output stage according to one of the preceding claims, characterised by complete construction as a monolithically integrated circuit.

8. Transistor output stage according to Claim 7, characterised in that an additional, lower-lying $\nu$ layer and $\pi$ layer for electrical isolation are provided in each case in order to produce the base and emitter layers of at least one part of the switching transistors (23', 27, 25).

9. Transistor output stage according to Claim 8, characterised in that the second lateral pnp switching transistor (23') is built up with the layers $\pi$, $n^-$, $\pi$, the base simultaneously being the collector of the power transistor (10).

10. Transistor output stage according to Claim 9, characterised in that the emitter resistor (29) of the second switching transistor (23') consists of $\nu$ material.

11. Transistor output stage according to one of the preceding claims, characterised in that the npn switching transistors (25, 27, 30, 31) consist of vertical n+, p+ and $\nu$ layers which are separated via high-resistance $\pi$ isolating troughs from the collector potential of the power transistor.

12. Transistor output stage according to one of the preceding claims, characterised in that the collector resistors (26, 28, 33, 34) of the npn switching transistors (25, 27, 30, 31) consist of $\nu$ material, while the emitter-base resistor (24) of the third switching transistor (25) consists of p+ material.

13. Transistor output stage according to one of the preceding claims, characterised in that an overvoltage protection device consisting of the series connection of a Zener diode (37) to a current-limiting resistor (38) is connected to the supply voltage source.

14. Transistor output stage according to Claim 13, characterised in that the Zener diode (37) consists of at least one $p^+$ - $\nu$ layer sequence.

## Revendications

1. Etage final de transistor notamment étage final d'allumage branché en série sur le primaire (11) d'une bobine d'allumage (12) et qui, pour détecter la chute de tension sur un utilisateur (11) à commuter par un transistor de puissance (10) de cet étage final de transistor, comporte un chemin base-émetteur d'un second transistor de commutation (23′) et en cas de chute de tension dans l'utilisateur (11), passant en dessous d'une chute de tension prédéterminée, très petite, correspondant à un court-circuit, coupe le passage du courant à travers le transistor de puissance (10), étage caractérisé en ce que l'émetteur du second transistor de commutation (23′) comporte une résistance d'émetteur (29) et le collecteur du second transistor de commutation (23′) comporte un troisième transistor de commutation (25) commandé par le courant de collecteur, le collecteur de ce troisième transistor étant relié d'une part par une résistance de limitation de courant (26) au pôle positif d'une source de tension d'alimentation (13) et d'autre part à l'entrée de base d'un premier transistor de commutation (27), le collecteur du premier transistor de commutation (27) étant relié à la base du transistor de puissance (10), pour diminuer le courant de base du transistor de puissance (10), le troisième transistor de commutation (25) bloquant le premier transistor de commutation (27) lorsqu'il est débloqué à l'état conducteur de courant, et le transistor de puissance (10) comporte une résistance d'entrée de base (32) dont la borne d'entrée est reliée à une entrée de commande (14) et est commandée par l'intermédiaire d'une résistance (41) à partir d'un quatrième transistor de commutation (30) servant à inverser le signal de commande appliqué à l'entrée de commande (14), ce quatrième transistor étant suivi par un cinquième transistor de commutation (31) dont la base est reliée par une résistance (33) au pôle positif de la source de tension d'alimentation (13) et dont le collecteur est relié à l'entrée de base du premier transistor de commutation (27) pour que le cinquième transistor de commutation (31) bloque le premier transistor de commutation (27) lorsqu'il n'y a pas de signal de commande du transistor de puissance (10).

2. Etage final de transistor selon la revendication 1, caractérisé en ce, que dans la réalisation monolithique intégrée, le collecteur du transistor de puissance (10) est relié à la base (n) du second transistor de commutation (23′) en forme de transistor latéral de type pnp.

3. Etage final de transistor selon les revendications 1 et 2, caractérisé en ce que le chemin émetteur-base du premier transistor de commutation (27) en forme de transistor npn est court-circuité par le troisième transistor de commutation (25).

4. Etage final de transistor selon l'une des revendications précédentes, caractérisé en ce que la base du transistor de puissance (10) est reliée par une résistance faiblement ohmique (28) d'une valeur inférieure à 200 ohms, au collecteur du premier transistor de commutation (27).

5. Etage final de transistor selon l'une des revendications précédentes, caractérisé en ce que le collecteur du troisième transistor de commutation (25) constitue la sortie de commande d'un élément de contrôle (36) tel qu'un voyant de contrôle.

6. Etage final de transistor selon l'une des revendications précédentes, caractérisé en ce qu'une résistance de collecteur (24) est prévue en série sur le second transistor de commutation (23′).

7. Etage final de transistor selon l'une des revendications précédentes, caractérisé en ce qu'il est complètement réalisé sous la forme d'un circuit monolithique intégré.

8. Etage final de transistor selon la revendication 7, caractérisé en ce que pour créer les couches base et émetteur d'au moins une partie des transistors de commutation (23′, 27, 25), il y a chaque fois une couche d'isolation plus profonde $\nu$ et $\pi$ pour l'isolation des potentiels.

9. Etage final de transistor selon la revendication 8, caractérisé en ce que le second transistor latéral pnp (23′) est formé des couches $\pi$, $n^-$, $\pi$ et la base est en même temps le collecteur du transistor de puissance (10).

10. Etage final de transistor selon la revendication 9, caractérisé en ce que la résistance d'émetteur (29) du second transistor de commutation (23') est en matière $\nu$.

11. Etage final de transistor selon l'une des revendications précédentes, caractérisé en ce que les transistors de commutation de type npn (25, 27, 30, 31) ont des couches verticales $n^+$, $p^+$ $\nu$, séparées du potentiel de collecteur du transistor de puissance par des cuvettes d'isolation $\pi$, fortement ohmiques.

12. Etage final de transistor selon l'une des revendications précédentes, caractérisé en ce que les résistances de collecteur (26, 28, 33, 34) des transistors de commutation npn (25, 27, 30, 31) sont en matière $\nu$ alors que la résistance émetteur-base (24) du troisième transistor de commutation (25) est en matière $p^+$.

13. Etage final de transistor selon l'une des revendications précédentes, caractérisé par un montage en série d'une diode Z (37) avec une résistance de limitation de courant (38) formant un dispositif de protection de surtension appliqué à la source de tension d'alimentation.

14. Etage final de transistor selon la revendication 13, caractérisé en ce que la diode Z (37) se compose d'au moins une succession de couches $p^+$ - $\nu$.

# FIG. 1

FIG. 2

## FIG. 3

## FIG. 4

## FIG. 5

FIG. 6

FIG.7